# EUROPEAN PATENT SPECIFICATION

(11) **EP 3 677 933 B1**
(45) Date of publication and mention of the grant of the patent: **21.06.2023**
(21) Application number: 19211823.0
(22) Date of filing: 27.11.2019
(51) Int. Cl.: G02B 1/10, G02B 1/113, G02B 1/115, G02B 1/12, G02B 1/14

(54) **OPTICAL MEMBERS, METHODS FOR PRODUCING THE SAME AND DISPLAY DEVICES COMPRISING THE SAME**
OPTISCHE ELEMENTE, VERFAHREN ZU IHRER HERSTELLUNG UND ANZEIGEVORRICHTUNGEN DAMIT
ÉLÉMENTS OPTIQUES, LEURS PROCÉDÉS DE PRODUCTION ET DISPOSITIFS D'AFFICHAGE LES COMPRENANT

(30) Priority: 13.12.2018 KR 20180161217
(43) Date of publication of application: 08.07.2020
(73) Proprietor: Samsung Electronics Co., Ltd., Gyeonggi-do 16677 (KR)
(72) Inventor: KWON, Myong Jong, Gyeonggi-do (KR); PARK, Byung Ha, Gyeonggi-do (KR); BAE, Jun Cheol, Gyeonggi-do (KR); KIM, Ginam, Gyeonggi-do (KR)
(74) Representative: Elkington and Fife LLP

(56) References cited:
- EP-A2- 2 778 252
- WO-A1-2016/176383
- WO-A1-2018/064947
- WO-A2-2018/192908

## Description

### FIELD OF THE INVENTION

Optical members, methods for producing the same, and display devices including the optical members are disclosed.

### BACKGROUND OF THE INVENTION

Portable electronic devices such as smart phones and tablet personal computers ("PCs") have been widely used. These portable electronic devices are often used outdoors as well as indoors, and therefore may be intended to provide visibility of a display thereof in an outdoors environment where ambient sunlight may be strong. In some example embodiments, these portable electronic devices may be configured to contact a hand or a pen and thus have mechanical durability. WO 2018/064947 and EP 2778252 disclose alumina based optical layers.

### SUMMARY OF THE INVENTION

Some example embodiments provide an optical member configured to satisfy visibility and mechanical durability needs simultaneously.

Some example embodiments provide a method of manufacturing such an optical member.

Some example embodiments provide a display device including such an optical member.

According to some example embodiments, an optical member may include a transparent substrate, an alumina-based first transparent ceramic layer on the transparent substrate, and an alumina-based second transparent ceramic layer on the alumina-based first transparent ceramic layer such that the alumina-based first transparent ceramic layer is between the transparent substrate and the alumina-based second transparent ceramic layer. The alumina-based first transparent ceramic layer and the alumina-based second transparent ceramic layer have independent compositions, and the independent compositions each be a silica-free composition. A refractive index of the alumina-based second transparent ceramic layer is smaller than a refractive index of the alumina-based first transparent ceramic layer.

The alumina-based first transparent ceramic layer may have a refractive index of about 1.55 to about 1.65. The alumina-based second transparent ceramic layer may have a refractive index of about 1.3 to about 1.5.

A density of the alumina-based second transparent ceramic layer may be smaller than a density of the alumina-based first transparent ceramic layer.

The alumina-based first transparent ceramic layer may have a density of about 2.8 g/cm³ to about 3.5 g/cm³, and the alumina-based second transparent ceramic layer may have a density of about 1.8 g/cm³ to about 2.4 g/cm³.

The alumina-based first transparent ceramic layer may have a thickness of about 50 nm to about 150 nm, and the alumina-based second transparent ceramic layer may have a thickness of about 20 nm to about 100 nm.

The alumina-based first transparent ceramic layer and the alumina-based second transparent ceramic layer independently include a phase-separation additive.

The phase-separation additive may include Na₂O, CaO, or any combination thereof.

An amount of the phase-separation additive in the alumina-based first transparent ceramic layer is larger than an amount of the phase-separation additive in the alumina-based second transparent ceramic layer.

The independent compositions may each include a material selected from MgAl₂O₄, aluminum oxynitride, or any combination thereof.

The alumina-based first transparent ceramic layer may have a non-porous structure.

The alumina-based second transparent ceramic layer may have a porous structure.

According to some example embodiments, a method of manufacturing an optical member may include preparing a transparent substrate, depositing an alumina-based ceramic material on the transparent substrate, the alumina-based ceramic material having a silica-free composition, and heat-treating and washing the alumina-based ceramic material after the depositing.

The alumina-based ceramic material having the silica-free composition may have a composition selected from MgAl₂O₄, aluminum oxynitride, or any combination thereof.

The alumina-based ceramic material having the silica-free composition may further include a phase-separation additive.

The heat-treating may be performed at a temperature of about 400 °C to about 600 °C for about 1 hour.

The heat-treating and the washing of the alumina-based ceramic material may include repeatedly heat-treating and washing the alumina-based ceramic material between one time and three times, inclusively, after the depositing.

The phase-separation additive may include Na₂O, CaO, or both Na₂O and CaO.

A display device may include the optical member.

According to some example embodiments, an optical member may include a transparent substrate, an alumina-based first transparent ceramic layer on the transparent substrate, and an alumina-based second transparent ceramic layer on the alumina-based first transparent ceramic layer such that the alumina-based first transparent ceramic layer is between the transparent substrate and the alumina-based second transparent ceramic layer. The alumina-based first transparent ceramic layer may have a non-porous structure and the alumina-based second transparent ceramic layer may have a porous structure. A refractive index of the alumina-based second transparent ceramic layer may be smaller than a refractive index of the alumina-based first transparent ceramic layer.

The alumina-based first transparent ceramic layer and the alumina-based second transparent ceramic layer have independent compositions, and the independent compositions are each a silica-free composition.

The alumina-based first transparent ceramic layer may have a refractive index of about 1.55 to about 1.65. The alumina-based second transparent ceramic layer may have a refractive index of about 1.3 to about 1.5.

A density of the alumina-based second transparent ceramic layer may be smaller than a density of the alumina-based first transparent ceramic layer.

The alumina-based first transparent ceramic layer may have a density of about 2.8 g/cm³ to about 3.5 g/cm³, and the alumina-based second transparent ceramic layer may have a density of about 1.8 g/cm³ to about 2.4 g/cm³.

The alumina-based first transparent ceramic layer may have a thickness of about 50 nm to about 150 nm, and the alumina-based second transparent ceramic layer may have a thickness of about 20 nm to about 100 nm.

The alumina-based first transparent ceramic layer and the alumina-based second transparent ceramic layer independently include a phase-separation additive.

The phase-separation additive may include Na₂O, CaO, or any combination thereof.

An amount of the phase-separation additive in the alumina-based first transparent ceramic layer may be larger than an amount of the phase-separation additive in the alumina-based second transparent ceramic layer.

The independent compositions may each include a material selected from MgAl₂O₄, aluminum oxynitride, or any combination thereof.

### BRIEF DESCRIPTION OF THE DRAWINGS

FIG. 1A is a view schematically showing a method of manufacturing an optical member according to some example embodiments.
FIG. 1B illustrates a flowchart illustrating a method of manufacturing the optical member according to some example embodiments.
FIG. 2 is a FE-SEM photograph of a member including a transparent substrate and an alumina-based ceramic material having a glass-free composition deposited on the transparent substrate, before heat-treating according to some example embodiments.
FIG. 3 is a FE-SEM photograph of a member including a transparent substrate and an alumina-based ceramic material having a glass-free composition deposited on the transparent substrate, after heat-treating and washing according to some example embodiments.
FIG. 4 is a cross-sectional view of a display device according to some example embodiments.
FIG. 5 is a cross-sectional view of a display device according to some example embodiments.
FIG. 6A is a schematic diagram of an electronic device according to some example embodiments.
FIG. 6B is a perspective view of an electronic device according to some example embodiments.
FIG. 6C is a cross-sectional view, along view line VIC-VIC' of FIG. 6B, of the electronic device of FIG. 6B according to some example embodiments.

### DETAILED DESCRIPTION OF THE EMBODIMENTS

Some example embodiments of the present disclosure will hereinafter be described in detail, and may be easily performed by a person having an ordinary skill in the related art. However, actually applied structures may be embodied in many different forms, and is not to be construed as limited to the example embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

In the drawings, parts having no relationship with the description are omitted for clarity of some example embodiments, and the same or similar constituent elements are indicated by the same reference numeral throughout the specification.

As used herein, a refractive index may refer to a refractive index at a wavelength of 550 nm.

Hereinafter, 'combination' may refer to a mixture of two or more and a stack structure of two or more.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

As used herein, an element that is "on" another element may be above or below the other element. In addition, an element that is "on" another element may be directly on the other element, such that the elements are in direct contact with each other, or may be indirectly on the other element, such that the elements are isolated from direct contact with each other by one or more interposing spaces and/or structures.

As used herein, a "composition" of an element may refer to the total material composition of said element. It will be understood that elements having "independent" compositions may have separate compositions that may be different compositions. It will be understood that an element described herein as having a "composition" of one or more materials may include an element having a total material composition that includes the one or more materials. It will be understood that an element described herein as having a composition that is free of one or more materials may include an element having a total material composition that excludes the one or more materials.

Hereinafter, some example embodiments will be described in detail so that a person skilled in the art would understand the same. This disclosure may, however, be embodied in many different forms and is not construed as limited to the example embodiments set forth herein.

Hereinafter, an optical member according to some example embodiments is described.

An optical member according to some example embodiments includes a transparent substrate, an alumina-based first transparent ceramic layer disposed on the transparent substrate, and an alumina-based second transparent ceramic layer disposed on the alumina-based first transparent ceramic layer, wherein the alumina-based first transparent ceramic layer and the alumina-based second transparent ceramic layer independently have a silica-free composition, a refractive index of the alumina-based second transparent ceramic layer is smaller than a refractive index of the alumina-based first transparent ceramic layer.

Recently, as uses of mobile display devices has become very popular, mobile display devices have been frequently used both indoors and outdoors. However, until now, mobile display devices have improved visibility in the room, but screen visibility is deteriorated in the outdoor environment (about 10 Lux or greater) where the sunlight is strong, which limits a use environment. This is because external light reflectance is higher than luminance of a display device itself in the outdoor, not in the room, and the screen visibility is not good. Therefore, a method of securing screen visibility by increasing the luminance of the mobile display device itself in order to increase the screen visibility in the outdoor environment has been tried. However, this is only a temporary measure, and finally, research on a mobile display device which may secure driving characteristics under a low power has been continued.

Conventionally, a reflectance is lowered by using a glass material, that is, a silica-containing nanomaterial in order to secure screen visibility in an outdoor environment. However, since the material itself is glass, its optical characteristics are improved, but the mechanical durability is greatly deteriorated.

In the optical member according to some example embodiments, the alumina-based transparent ceramic layer having a silica-free composition is placed on a transparent substrate, the alumina-based transparent ceramic layer is divided into two layers, and each of the alumina-based transparent ceramic layer have different refractive indexes, and thereby high hardness and low reflection characteristics may be satisfied at the same time. In other words, according to the optical member according to some example embodiments, both outdoor visibility and mechanical durability may be provided with an excellent display device and the like.

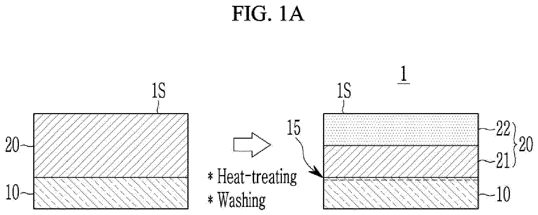

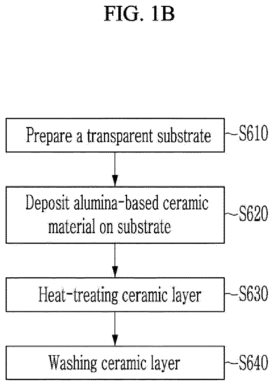

FIG. 1A is a view schematically showing a method of manufacturing an optical member according to some example embodiments. FIG. 1B illustrates a flowchart illustrating a method of manufacturing the optical member according to some example embodiments.

Referring to FIG. 1A, the optical member 1 according to some example embodiments includes a transparent substrate 10 and an alumina-based transparent ceramic layer 20 disposed on the transparent substrate 10 and having a silica-free composition (e.g., a total material composition that does not include any silica, e.g., silicon dioxide (SiO₂)). In some example embodiments, as shown in at least FIG. 1A, the alumina-based transparent ceramic layer 20 having the silica-free composition may at least partially comprise an alumina-based first transparent ceramic layer 21 on the transparent substrate 10 and an alumina-based second transparent ceramic layer 22 on the alumina-based first transparent ceramic layer 21, such that the alumina-based first transparent ceramic layer 21 is between the transparent substrate 10 and the alumina-based second transparent ceramic layer 22. The alumina-based first transparent ceramic layer 21 and the alumina-based second transparent ceramic layer 22 may each independently have a silica-free composition (i.e., may have independent compositions that are each silica-free). The alumina-based first transparent ceramic layer 21 may have ("may be associated with") a high refractive index and the alumina-based second transparent ceramic layer 22 may have a low refractive index. That is, a refractive index of the alumina-based second transparent ceramic layer may be smaller than a refractive index of the alumina-based first transparent ceramic layer.

The transparent substrate 10 may be a glass or polymer substrate, and the polymer substrate may include, in some example embodiments, polyimide, polyamide, polyamideimide, polyethyleneterephthalate, polyethylenenaphthalene, polymethylmethacrylate, polycarbonate, a copolymer thereof, or any combination thereof, but is not limited thereto.

The transparent substrate 10 may be for example glass, for example tempered glass.

The transparent substrate 10 may have for example a light transmittance of greater than or equal to about 92 % and a reflectance of less than or equal to about 8 %. The transparent substrate 10 may have for example a thickness of less than or equal to about 500 µm, for example about 25 µm to about 500 µm or about 50 µm to about 500 µm.

The alumina-based transparent ceramic layer 20 may have any one composition selected from MgAl₂O₄ (Mg-spinel), aluminum oxynitride (Al₂₃O₂₇N₅; ALON), or any combination thereof. When the alumina-based transparent ceramic layer 20 has an alumina-based composition instead of a conventional silica-based composition, hardness (mechanical characteristics) may be greatly improved (in some example embodiments, Mohs hardness is 7 in the case of the conventional silica-based composition, and Mohs hardness in the case of the alumina-based composition is 9). In some example embodiments, the surface 1S of the optical member 1 (also referred to herein as an outer surface of the optical member 1 and also referred to herein as an outer surface of the alumina-based second transparent ceramic layer 22) may have scratch resistance, high surface hardness, and pencil hardness. It will be understood that the outer surface 1S, which may be the surface of the optical member 1 that is distal from the transparent substrate 10, may be a surface that is directly exposed to an ambient environment that is external to the optical member 1, including an ambient environment that is external to a display device and/or electronic device in which the optical member 1 is included. In some example embodiments, the optical member 1 may have a surface hardness of greater than or equal to about 7.0 GPa, greater than or equal to about 7.1 GPa, greater than or equal to about 7.2 GPa, greater than or equal to 7.3 GPa, or greater than or equal to 7.4 GPa, . In some example embodiments, the optical member 1 may have a pencil hardness of greater than or equal to about 5H, greater than or equal to about 6H, greater than or equal to about 7H, greater than or equal to about 8H, or greater than or equal to about 9H.

The alumina-based transparent ceramic layer 20 further includes a phase-separation additive. In some example embodiments, when the alumina-based transparent ceramic layer 20 is subjected to a heat-treating process, the alumina-based transparent ceramic layer 20 may be separated into two layers having different physical properties. In some example embodiments, the alumina-based transparent ceramic layer adjacent to the transparent substrate 10 is an alumina-based first transparent ceramic layer 21 having a high density, and the alumina-based transparent ceramic layer not adjacent to the transparent substrate 10 is an alumina-based second transparent ceramic layer 22 of a porous structure.

The alumina-based first transparent ceramic layer 21 and the alumina-based second transparent ceramic layer 22 may independently have a composition selected from MgAl₂O₄ (Mg-spinel), aluminum oxynitride (Al₂₃O₂₇N₅; ALON), or any combination thereof. Restated, the alumina-based first transparent ceramic layer 21 and the alumina-based second transparent ceramic layer 22 may have independent compositions, and the independent compositions may each include a material selected from MgAl₂O₄ (Mg-spinel), aluminum oxynitride (Al₂₃O₂₇N₅; ALON), or any combination thereof.

A refractive index of the alumina-based second transparent ceramic layer 22 may be smaller than a refractive index of the alumina-based first transparent ceramic layer 21, and in some example embodiments, the optical member according to some example embodiments may have high hardness and low reflection characteristics at the same time based on including such alumina-based first and second transparent ceramic layers 21 and 22.

The alumina-based first transparent ceramic layer 21 may have a refractive index of about 1.55 to about 1.65 and the alumina-based second transparent ceramic layer 22 may have a refractive index of about 1.3 to about 1.5.

The alumina-based transparent ceramic layer 20 may include Na₂O, CaO, or any combination thereof as a phase-separation additive. The alumina-based transparent ceramic layer 20 includes a phase-separation additive. The alumina-based first transparent ceramic layer 21 and the alumina-based second transparent ceramic layer 22 which are separated by heat-treating independently include the phase-separation additive, for example Na₂O, CaO or any combination thereof. Restated, the alumina-based first transparent ceramic layer 21 and the alumina-based second transparent ceramic layer 22 may have independent compositions and each include, in the respective independent compositions, a phase-separation additive, where the phase-separation additive includes Na₂O, CaO, or any combination thereof.

In the embodiments, an amount of the phase-separate additive in the alumina-based first transparent ceramic layer 21 is larger than an amount of the phase-separation additive in the alumina-based second transparent ceramic layer 22. An amount of the phase-separation additive of ("in") the alumina-based first and second transparent ceramic layers is not significantly different after deposition, and the phase-separation additive of the outer surface 1S is precipitated from the alumina-based first and second transparent ceramic layers through heat-treating, and the precipitated material is dissolved in ultrapure water to form a porous structure. In other words, there is no difference in the amounts of the initial phase-separation additives of the first and second transparent ceramic layers and a concentration of the phase-separation additive in the second transparent ceramic layer, through ("based on") the heat-treating and washing process, is lower than that of the phase-separation additive of the first transparent ceramic layer. Specifically, through the heat-treating of the alumina-based transparent ceramic layer 20 including the phase-separation additive, a phase-separation additive-based material is phase-separated and precipitated in a part of the alumina-based transparent ceramic layer 20, and then, when the precipitated phase-separation additive-based material is washed with purified water and the like, the part of the alumina-based transparent ceramic layer 20, that is, the alumina-based second transparent ceramic layer 22 has a porous structure. The alumina-based second transparent ceramic layer 22 having the porous structure may play a role of a low reflection layer. In some example embodiments, the alumina-based first transparent ceramic layer 21 may have a non-porous structure. In some example embodiments, the alumina-based second transparent ceramic layer 22 may have a porous structure. In some example embodiments, only the alumina-based second transparent ceramic layer 22 has the porous structure having nanopores, that is, the part of the alumina-based transparent ceramic layer 20 has the low reflection layer of the porous structure, and accordingly, since the low reflection layer (the alumina-based second transparent ceramic layer) and a high hardness layer (the alumina-based first ceramic layer of a non-porous structure) are integrated into one body, the optical member according to some example embodiments may simultaneously improve mechanical characteristics and optical properties.

Furthermore, whether or not the porous structure is present brings about the aforementioned refractive index difference, that is, has an influence on making a refractive index of the alumina-based second transparent ceramic layer 22 smaller than that of the alumina-based first transparent ceramic layer 21 and thus may contribute to realizing excellent mechanical characteristics and optical properties of the optical member according to some example embodiments.

In comparative examples not falling within the scope of the claims, one or both of the alumina-based first and second transport ceramic layers 21 and 22 may include at least some silica and may still provide improved reflection reduction (e.g., improved visibility) and hardness based at least in part upon the alumina-based second transport ceramic layer 22 having a porous structure, and the alumina-based first transport ceramic layer 21 having a non-porous structure, such that the alumina-based second transport ceramic layer 22 has a lower refractive index than the alumina-based first transport ceramic layer 21, despite one or both of the alumina-based first and second transport ceramic layers 21 and 22 including at least some silica.

In some example embodiments, a density of the alumina-based second transparent ceramic layer 22 may be smaller than that of the alumina-based first transparent ceramic layer 21. The alumina-based second transparent ceramic layer 22 has a smaller density than that of the alumina-based first transparent ceramic layer 21 and thus may improve mechanical characteristics. In other words, mechanical characteristics all over the optical member may be improved by forming a high density layer under a low density layer.

In some example embodiments, the alumina-based first transparent ceramic layer 21 may have a density of about 2.8 g/cm³ to about 3.5 g/cm³, and the alumina-based second transparent ceramic layer 22 may have a density of about 1.8 g/cm³ to about 2.4 g/cm³.

The alumina-based first transparent ceramic layer 21 may have a thickness of about 50 nm to about 150 nm, in some example embodiments, a thickness of about 80 nm to about 150 nm, and in some example embodiments, a thickness of about 100 nm to about 150 nm. The alumina-based second transparent ceramic layer 22 may have a thickness of about 20 nm to about 100 nm, in some example embodiments, a thickness of about 30 nm to about 80 nm, and in some example embodiments, a thickness of about 30 nm to about 75 nm.

The optical member 1 may be a transparent optical member and for example satisfy light transmittance of greater than or equal to about 93 % and haze of less than or equal to about 0.5, in some example embodiments, less than or equal to about 0.4, in some example embodiments, less than or equal to about 0.3, and in some example embodiments, less than or equal to about 0.2.

In some example embodiments, an optical member according to some example embodiments may further include an auxiliary layer 15 between the transparent substrate 10 and the alumina-based transparent ceramic layer 20 and specifically, between the transparent substrate 10 and the alumina-based first transparent ceramic layer 21, unlike the optical member according to some example embodiments.

The auxiliary layer may be a high refractive layer having a higher refractive index than that of the alumina-based first transparent ceramic layer 21 and in some example embodiments, have a refractive index of greater than or equal to about 1.7. The auxiliary layer may for example include TiO₂, ZrO₂, or any combination thereof but is not limited thereto and may for example have a thickness of about 10 nm to about 140 nm.

The optical member 1 according to some example embodiments further includes the auxiliary layer and thus may much improve anti-reflection characteristics.

Hereinafter, an example of a method of manufacturing the optical member of Fig. 1A will be described, for example with reference to FIG. 1B.

Referring to FIG. 1B, some example embodiments provide a method of manufacturing an optical member that includes preparing a transparent substrate (S610); depositing an alumina-based ceramic material having a silica-free composition on the transparent substrate (S620); and heat-treating (S630) and washing (S640) the ceramic material after deposition.

The depositing of an alumina-based ceramic material having a silica-free composition on the transparent substrate may be performed by a thin film deposition process by sputtering, but is not limited thereto.

The alumina-based ceramic material having the silica-free composition may have a composition selected from MgAl₂O₄, aluminum oxynitride, or any combination thereof. The alumina-based ceramic material may include a phase-separation additive. The phase-separation additive may include, for example Na₂O, CaO, or both Na₂O and CaO.

The heat-treating may be performed at (e.g., the heat-treating may include exposing the alumina-based ceramic material to an ambient temperature of and/or heating the alumina-based ceramic material to a temperature of) about 400 °C to about 600 °C, in some example embodiments, at about 450 °C to about 550 °C, and in some example embodiments, at about 500 °C for about 30 minutes to about 2 hours, in some example embodiments, for about 40 minutes to about 90 minutes, and in some example embodiments, for about 1 hour. When the heat-treating is performed, a phase-separation and a precipitation may occur on the surface of the alumina-based ceramic material having a silica-free composition due to the phase-separation additive and thus form the alumina-based first transparent ceramic layer 21 having a non-porous structure and the alumina-based second transparent ceramic layer 22 having a porous structure. Accordingly, an optical member may, in some example embodiments, include a transparent substrate 10, an alumina-based first transparent ceramic layer 21 on the transparent substrate 10, and an alumina-based second transparent ceramic layer 22 on the alumina-based first transparent ceramic layer 21 such that the alumina-based first transparent ceramic layer 21 is between the transparent substrate 10 and the alumina-based second transparent ceramic layer 22. The alumina-based first transparent ceramic layer 21 and the alumina-based second transparent ceramic layer 22 may have independent compositions. The alumina-based first transparent ceramic layer 21 may have a non-porous structure and the alumina-based second transparent ceramic layer 22 may have a porous structure. The alumina-based first transparent ceramic layer 21 and the alumina-based second transparent ceramic layer 22 may have independent compositions. One or more of the independent composition of the alumina-based first transparent ceramic layer 21 or the independent composition of the alumina-based second transparent ceramic layer 22 may be silica-free or may include silica. A refractive index of the alumina-based second transparent ceramic layer 22 may be smaller than a refractive index of the alumina-based first transparent ceramic layer 21.

In some example embodiments, the heat-treating and the washing may be once or twice to three times repetitively performed after the deposition. Restated, the heat-treating and the washing of the alumina-based ceramic material may include repeatedly heat-treating and washing the alumina-based ceramic material between one time and three times, inclusively, after depositing the alumina-based ceramic material on the transparent substrate.

As the heat-treating and the washing are more repeated, the alumina-based second transparent ceramic layer 22 becomes thicker gradually, but the alumina-based first transparent ceramic layer 21 becomes thinner gradually. Accordingly, as the heat-treating and the washing are repeated, optical properties become excellent (reflectance becomes lower and lower), but mechanical characteristics such as surface hardness and the like are deteriorated, and accordingly, the heat-treating and the washing may be once to three times performed.

The washing may be performed for about 30 seconds to about 5 minutes, in some example embodiments, about 30 seconds to about 3 minutes, and in some example embodiments, for about 1 minute by using distilled water and the like.

Some example embodiments provide a display device including the optical member 1.

The optical member may be applied to a window for a display device.

The window for a display device may realize anti-reflection characteristics and hard coating characteristics and/or scratch resistance characteristics due to the optical member simultaneously and thus may ensure visibility and mechanical durability at the same time.

The window for a display device may further include another auxiliary layer (not shown) on the lower and/or upper surfaces (e.g., outer surfaces) of the optical member.

The window for a display device may be applied to various electronic devices. The electronic devices may be display devices, for example liquid crystal displays (LCD) or organic light emitting diode (OLED) displays, but are not limited thereto.

The window for a display device may be attached on the display panel. Herein, the display panel and the window for a display device may be directly bonded or may be bonded by interposing an adhesive.

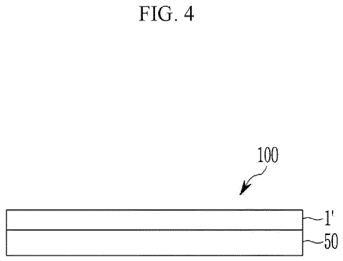

FIG. 4 is a cross-sectional view showing a display device according to some example embodiments.

Referring to FIG. 4, a display device 100 according to some example embodiments includes a display panel 50, window 1' for a display device and an adhesion layer (not shown).

The display panel 50 may be for example an organic light emitting display panel or a liquid crystal display panel.

The window 1' for a display device may be disposed on the side of an observer and the structure may be the same as the optical member 1. Restated, the window 1' may be the optical member 1 as described herein.

The display panel 50 and the window 1' for a display device may be bonded by the adhesion layer. The adhesion layer may include a tackifier or an adhesive, for example optical clear adhesive (OCA). The adhesion layer may be omitted.

Another layer may be further disposed between the display panel 50 and the window 1' for a display device and may include for example a monolayer or plural layers of polymer layer (not shown) and optionally a transparent adhesive layer (not shown).

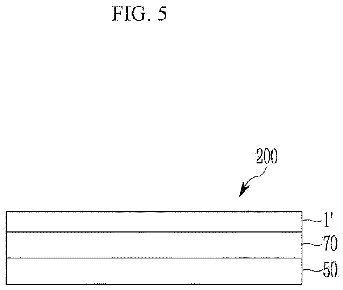

FIG. 5 is a cross-sectional view of a display device according to some example embodiments.

Referring to FIG. 5, a display device 200 according to some example embodiments includes a display panel 50, a window 1' for a display device, and a touch panel 70 disposed between the display panel 50 and the window 1' for a display device.

The display panel 50 may be for example an organic light emitting panel or a liquid crystal panel.

The window 1' for a display device may be disposed on the side of an observer and its structure may be the same as the optical member 1. Restated, the window 1' may be the optical member 1 as described herein.

The touch panel 70 may be disposed adjacent to each of the window 1' for a display device and the display panel 50 to recognize the touched position and the position change when is touched by a human hand or an object through the window 1' for a display device and then to output a touch signal. The driving module (not shown) may monitor a position where is touched from the output touch signal, recognize an icon marked at the touched position, and control to carry out functions corresponding to the recognized icon, and the function performance results are displayed on the display panel 50.

Another layer may be further disposed between the touch panel 70 and the window 1' for a display device, and may include for example a monolayer or plural layers of polymer layer (not shown) and optionally a transparent adhesive layer (not shown).

The display device may be applied to a variety of electronic devices, for example a smart phone, a tablet PC, a camera, a touch screen device, and so on, but is not limited thereto.

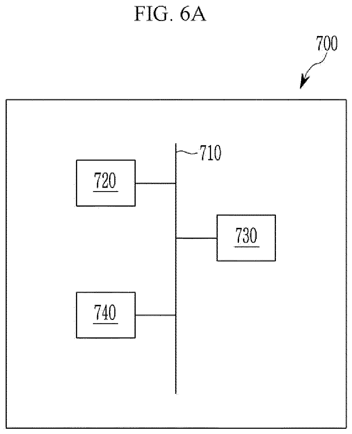

FIG. 6A is a schematic diagram of an electronic device 700 according to some example embodiments.

As shown in FIG. 6A, an electronic device 700 may include a processor 720, a memory 730, and a display device 740 that are electrically coupled together via a bus 710. The display device 740 may be a display device any of the example embodiments as described herein (e.g., display device 100 and/or display device 200), including a display device including at least the window 1' (e.g., optical member 1) according to any of the example embodiments described herein. The memory 730, which may be a non-transitory computer readable medium, may store a program of instructions. The processor 720 may execute the stored program of instructions to perform one or more functions. For example, the processor 720 may be configured to process electric signals generated by the display device 740. The processor 720 may be configured to generate an output (e.g., an image to be displayed on the display device 740) based on processing the electric signals.

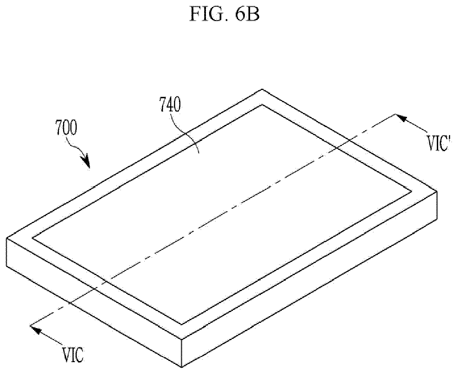

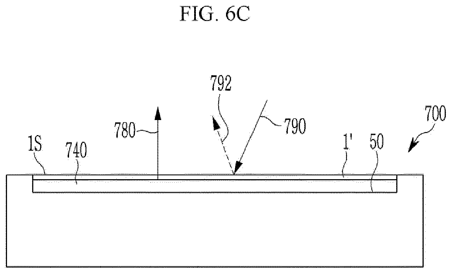

FIG. 6B is a perspective view of an electronic device 700 according to some example embodiments. FIG. 6C is a cross-sectional view, along view line VIC-VIC' of FIG. 6B, of the electronic device 700 of FIG. 6B according to some example embodiments. The electronic device 700 shown in FIGS. 6B-6C may be the electronic device 700 shown in FIG. 6A.

As shown in FIGS. 6B-6C, an electronic device 700 may include a display device 740 that includes at least a display panel 50 and a window 1' on the display panel 50. The display device 740 may include a touch panel 70 between the window 1' and the display panel 50.

As shown in FIG. 6C, the window 1' may exhibit reduced reflectance 792 of incident ambient light 790 (e.g., sunlight), thereby improving visibility of light 780 emitted by the display panel 50 of the display device 740 in outdoor environments, and the display device 740 may simultaneously have improved hardness, particularly of the outer surface 1S of the window 1' (e.g., optical member 1) that is directly exposed to an ambient environment external to the electronic device 700.

Hereinafter, some example embodiments are illustrated in more detail with reference to examples. However, these examples are exemplary, and the present scope is not limited thereto.

### Manufacture of Optical Member

### Example 1

An optical member is manufactured by depositing MgAl₂O₄ (Mg-Spinel) and Na₂O through sputtering on a glass wafer, a transparent substrate, once heat-treating it at 500 °C for 1 hour, and washing it with D.I. water for 1 minute.

### Example 2

An optical member is manufactured according to the same method as Example 1 except that the heat-treating is performed twice instead of once.

### Example 3

An optical member is manufactured according to the same method as Example 1 except that the heat-treating is performed three times instead of once.

### Comparative Example 1

An optical member is manufactured according to the same method as Example 1 except that the heat-treating is not performed.

### Comparative Example 2

An optical member is manufactured by spin-coating a coating material containing about 3 % of hollow silica particles and polyhedral oligomeric silsesquioxane (POSS) in IPA (Isopropyl alcohol) on a glass wafer, a transparent substrate, and heat-treating it at 500 °C for 30 minutes.

### Evaluation 1

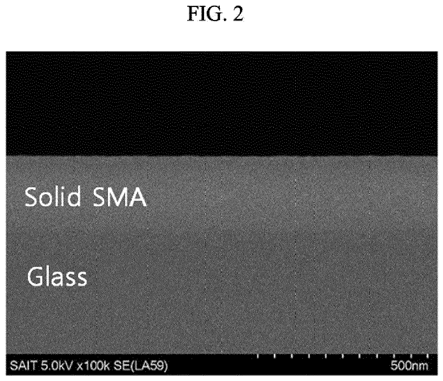

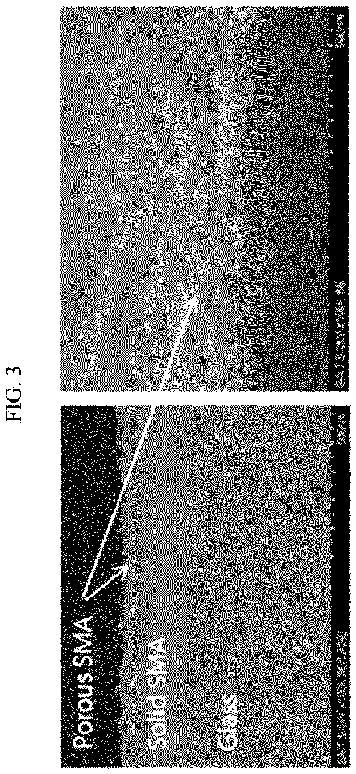

MgAl₂O₄ (Mg-Spinel) and Na₂O are deposited trough sputtering on a glass wafer, a transparent substrate, and a FE-SEM photograph thereof is shown in FIG. 2, and then, the deposited materials are once heat-treated at 500 °C for 1 hour and washed with D.I water for 1 minute, and a FE-SEM photograph thereof is shown in FIG. 3.

Referring to FIGS. 2 and 3, an alumina-based ceramic material having a glass-free composition ("silica-free composition") are not separated into two layers before the heat-treating but separated into a porous layer (an alumina-based second transparent ceramic layer) and a high hardness layer (an alumina-based first transparent ceramic layer) after the heat-treating.

### Evaluation 2

Each thickness of the optical members according to Examples 1 to 3 and Comparative Examples 1 and 2 is evaluated.

The thickness is evaluated by measuring thicknesses of the alumina-based transparent ceramic layers on a substrate by using FE-SEM of FIG. 3.

The results are shown in Table 1.

**(Table 1)**

| | Thin film thickness | | |
|---|---|---|---|
| | Alumina-based second transparent ceramic layer | Alumina-based first transparent ceramic layer | Total |
| Example 1 | 36.7 | 148.5 | 185.2 |
| Example 2 | 64.3 | 111.0 | 175.3 |
| Example 3 | 74.3 | 101.5 | 175.8 |
| Comparative Example 1 | 0.0 | 185.8 | 185.8 |
| Comparative Example 2 | - | | 150.0 |

Referring to Table 1, the optical members according to Examples 1 to 3 have the same thickness as or a larger thickness than the optical members according to Comparative Examples 1 and 2.

### Evaluation 3

Mechanical characteristics (surface hardness) and optical properties (a refractive index, light transmittance, haze) of the optical members according to Examples 1 to 3 and Comparative Examples 1 and 2 are evaluated.

The surface hardness is measured by using a nanoindenter (Fischerscope HM2000, Fisher Technology Inc.) under a load of 10 mN for 20 seconds.

The refractive index is measured within a wavelength range of about 380 nm to 760 nm by using Ellipsometer (J.A.Woollam Co., Inc.).

The light transmittance and the haze are measured by using a UV spectrometer (Spectrophotometer cm-3600d, KONICA MINOLTA Inc.), and in some example embodiments, the haze is measured according to D1003-97 A, and the yellow index is measured according to D1925. The light transmittance for example covers an entire visible ray region of about 380 nm to 700 nm.

The results are shown in Table 2.

**(Table 2)**

| | Mechanical characteristics | Optical properties | | | |
|---|---|---|---|---|---|
| | Surface hardness (GPa) | Refractive index (@550nm) (%) | | Light transmitta nce (@550nm) (%) | Haze (%) |
| | | Alumina-based first transparent ceramic layer | Alumina-based second transparent ceramic layer | | |
| Example 1 | 7.4 | 1.592 | 1.459 | 93.5 | 0.2 |
| Example 2 | 7.3 | 1.588 | 1.411 | 93.9 | 0.2 |
| Example 3 | 7.2 | 1.586 | 1.359 | 94.3 | 0.2 |
| Comparative Example 1 | 7.7 | 1.613 | 1.611 | 91.6 | 0.2 |
| Comparative Example 2 | 4.5 | 1.361 | | 95.0 | 0.2 |
| | | (In Comparative Example 2, a refractive index of an entire thin film is measured ) | | | |

Referring to Table 2, the optical members according to Examples 1 to 3 exhibit excellent optical properties and mechanical characteristics compared with the optical members according to Comparative Examples 1 and 2.

While this disclosure has been described in connection with what is presently considered to be practical example embodiments, it is to be understood that the inventive concepts are not limited to the disclosed example embodiments. On the contrary, it is intended to cover various modifications included within the scope of the appended claims.

### <Description of Symbols>

1: optical member
1': window for a display device
10: transparent substrate
20: alumina-based transparent ceramic layer
21: alumina-based first transparent ceramic layer
22: alumina-based second transparent ceramic layer
50: display panel
70: touch screen panel
100, 200: display device

## Claims

1. An optical member, comprising:
a transparent substrate;
an alumina-based first transparent ceramic layer on the transparent substrate; and
an alumina-based second transparent ceramic layer on the alumina-based first transparent ceramic layer such that the alumina-based first transparent ceramic layer is between the transparent substrate and the alumina-based second transparent ceramic layer,
wherein the alumina-based first transparent ceramic layer and the alumina-based second transparent ceramic layer have independent compositions, and the independent compositions are each a silica-free composition,
wherein a refractive index of the alumina-based second transparent ceramic layer is smaller than a refractive index of the alumina-based first transparent ceramic layer,
wherein the alumina-based first transparent ceramic layer and the alumina-based second transparent ceramic layer independently include a phase-separation additive, and
wherein an amount of the phase-separation additive in the alumina-based first transparent ceramic layer is larger than an amount of the phase-separation additive in the alumina-based second transparent ceramic layer.

2. The optical member of claim 1, wherein
the alumina-based first transparent ceramic layer has a refractive index of 1.55 to 1.65, and
the alumina-based second transparent ceramic layer has a refractive index of 1.3 to 1.5.

3. The optical member of claims 1 or 2, wherein a density of the alumina-based second transparent ceramic layer is smaller than a density of the alumina-based first transparent ceramic layer;
preferably wherein
the alumina-based first transparent ceramic layer has a density of 2.8 g/cm³ to 3.5 g/cm³, and
the alumina-based second transparent ceramic layer has a density of 1.8 g/cm³ to 2.4 g/cm³.

4. The optical member of any of claims 1-3, wherein
the alumina-based first transparent ceramic layer has a thickness of 50 nm to 150 nm, and the alumina-based second transparent ceramic layer has a thickness of 20 nm to 100 nm.

5. The optical member of any of claims 1-4, wherein the phase-separation additive includes Na₂O, CaO, or any combination thereof.

6. The optical member of any of claims 1-5, wherein the independent compositions each include a material selected from MgAl₂O₄, aluminum oxynitride, or any combination thereof; and/or
wherein the alumina-based first transparent ceramic layer has a non-porous structure, preferably wherein the alumina-based second transparent ceramic layer has a porous structure.

7. A method of manufacturing the optical member of any of claims 1-6, the method comprising:
preparing a transparent substrate;
depositing an alumina-based ceramic material on the transparent substrate, the alumina-based ceramic material having a silica-free composition; and
heat-treating and washing the alumina-based ceramic material after the depositing.

8. The method of claim 7, wherein the alumina-based ceramic material having the silica-free composition has a composition selected from MgAl₂O₄, aluminum oxynitride, or any combination thereof;
wherein the alumina-based ceramic material having the silica-free composition further includes a phase-separation additive; and/or
wherein the heat-treating is performed at a temperature of 400 °C to 600 °C for 1 hour; and/or
wherein the heat-treating and the washing of the alumina-based ceramic material includes repeatedly heat-treating and washing the alumina-based ceramic material between one time and three times, inclusively, after the depositing, preferably wherein the phase-separation additive includes Na₂O, CaO, or both Na₂O and CaO.

9. A display device comprising the optical member of any of claims 1-6.

## Patentansprüche

1. Optisches Element, umfassend:
ein transparentes Substrat;
eine auf Aluminiumoxid basierende erste transparente Keramikschicht auf dem transparenten Substrat; und
eine auf Aluminiumoxid basierende zweite transparente Keramikschicht auf der auf Aluminiumoxid basierenden ersten transparenten Keramikschicht derart, dass sich die auf Aluminiumoxid basierende erste transparente Keramikschicht zwischen dem transparenten Substrat und der auf Aluminiumoxid basierenden zweiten transparenten Keramikschicht befindet,
wobei die auf Aluminiumoxid basierende erste transparente Keramikschicht und die auf Aluminiumoxid basierende zweite transparente Keramikschicht unabhängige Zusammensetzungen aufweisen und die unabhängigen Zusammensetzungen jeweils eine siliciumdioxidfreie Zusammensetzung sind,
wobei ein Brechungsindex der auf Aluminiumoxid basierenden zweiten transparenten Keramikschicht kleiner als ein Brechungsindex der auf Aluminiumoxid basierenden ersten transparenten Keramikschicht ist,
wobei die auf Aluminiumoxid basierende erste transparente Keramikschicht und die auf Aluminiumoxid basierende zweite transparente Keramikschicht unabhängig voneinander ein Phasentrennungsadditiv beinhalten, und
wobei eine Menge des Phasentrennungsadditivs in der auf Aluminiumoxid basierenden ersten transparenten Keramikschicht größer als eine Menge des Phasentrennungsadditivs in der auf Aluminiumoxid basierenden zweiten transparenten Keramikschicht ist.

2. Optisches Element nach Anspruch 1, wobei
die auf Aluminiumoxid basierende erste transparente Keramikschicht einen Brechungsindex von 1,55 bis 1,65 aufweist, und
die auf Aluminiumoxid basierende zweite transparente Keramikschicht einen Brechungsindex von 1,3 bis 1,5 aufweist.

3. Optisches Element nach Anspruch 1 oder 2, wobei eine Dichte der auf Aluminiumoxid basierenden zweiten transparenten Keramikschicht kleiner als eine Dichte der auf Aluminiumoxid basierenden ersten transparenten Keramikschicht ist;
bevorzugt wobei
die auf Aluminiumoxid basierende erste transparente Keramikschicht eine Dichte von 2,8 g/cm³ bis 3,5 g/cm³ aufweist und
die auf Aluminiumoxid basierende zweite transparente Keramikschicht eine Dichte von 1,8 g/cm³ bis 2,4 g/cm³ aufweist.

4. Optisches Element nach einem der Ansprüche 1-3, wobei
die auf Aluminiumoxid basierende erste transparente Keramikschicht eine Dicke von 50 nm bis 150 nm aufweist und die auf Aluminiumoxid basierende zweite transparente Keramikschicht eine Dicke von 20 nm bis 100 nm aufweist.

5. Optisches Element nach einem der Ansprüche 1-4, wobei das Phasentrennungsadditiv Na₂O, CaO oder eine beliebige Kombination davon beinhaltet.

6. Optisches Element nach einem der Ansprüche 1-5, wobei die unabhängigen Zusammensetzungen jeweils ein Material beinhalten, das aus MgAl₂O₄, Aluminiumoxynitrid oder einer beliebigen Kombination davon ausgewählt ist; und/oder
wobei die auf Aluminiumoxid basierende erste transparente Keramikschicht eine nicht poröse Struktur aufweist, bevorzugt wobei die auf Aluminiumoxid basierende zweite transparente Keramikschicht eine poröse Struktur aufweist.

7. Verfahren zum Herstellen des optischen Elements nach einem der Ansprüche 1-6, wobei das Verfahren umfasst:
Vorbereiten eines transparenten Substrats;
Abscheiden eines auf Aluminiumoxid basierenden Keramikmaterials auf dem transparenten Substrat, wobei das auf Aluminiumoxid basierende Keramikmaterial eine siliciumdioxidfreie Zusammensetzung aufweist; und
Wärmebehandeln und Waschen des auf Aluminiumoxid basierenden Keramikmaterials nach dem Abscheiden.

8. Verfahren nach Anspruch 7, wobei das auf Aluminiumoxid basierende Keramikmaterial, das die siliciumdioxidfreie Zusammensetzung aufweist, eine Zusammensetzung aufweist, die aus MgAl₂O₄, Aluminiumoxynitrid oder einer beliebigen Kombination davon ausgewählt ist;
wobei das auf Aluminiumoxid basierende Keramikmaterial, das die siliciumdioxidfreie Zusammensetzung aufweist, ferner ein Phasentrennungsadditiv beinhaltet; und/oder
wobei des Wärmebehandeln bei einer Temperatur von 400 °C bis 600 °C für 1 Stunde durchgeführt wird; und/oder
wobei das Wärmebehandeln und das Waschen des auf Aluminiumoxid basierenden Keramikmaterials wiederholtes Wärmebehandeln und Waschen des auf Aluminiumoxid basierenden Keramikmaterials zwischen einmal und einschließlich dreimal nach dem Abscheiden beinhaltet, bevorzugt wobei das Phasentrennungsadditiv Na₂O, CaO oder beide Na₂O und CaO beinhaltet.

9. Anzeigevorrichtung, das optische Elements nach einem der Ansprüche 1-6 umfassend.

## Revendications

1. Elément optique, comprenant :
un substrat transparent ;
une première couche céramique transparente à base d'alumine sur le substrat transparent ; et
une seconde couche céramique transparente à base d'alumine sur la première couche céramique transparente à base d'alumine de sorte que la première couche céramique transparente à base d'alumine se trouve entre le substrat transparent et la seconde couche céramique transparente à base d'alumine,
ladite première couche céramique transparente à base d'alumine et ladite seconde couche céramique transparente à base d'alumine possédant des compositions indépendantes, et lesdites compositions indépendantes étant chacune une composition sans silice,
un indice de réfraction de la seconde couche céramique transparente à base d'alumine étant inférieur à un indice de réfraction de la première couche céramique transparente à base d'alumine, ladite première couche céramique transparente à base d'alumine et ladite seconde couche céramique transparente à base d'alumine comprenant indépendamment un additif de séparation de phase, et
une quantité de l'additif de séparation de phase dans la première couche céramique transparente à base d'alumine étant supérieure à une quantité de l'additif de séparation de phase dans la seconde couche céramique transparente à base d'alumine.

2. Élément optique selon la revendication 1,
ladite première couche de céramique transparente à base d'alumine possédant un indice de réfraction de 1,55 à 1,65, et
ladite seconde couche céramique transparente à base d'alumine possédant un indice de réfraction de 1,3 à 1,5.

3. Elément optique selon la revendication 1 ou 2, une densité de la seconde couche céramique transparente à base d'alumine étant inférieure à une densité de la première couche céramique transparente à base d'alumine ;
de préférence
ladite première couche de céramique transparente à base d'alumine possédant une densité de 2,8 g/cm³ à 3,5 g/cm³, et
ladite seconde couche céramique transparente à base d'alumine possédant une densité de 1,8 g/cm³ à 2,4 g/cm³.

4. Elément optique selon l'une quelconque des revendications 1 à 3,
ladite première couche de céramique transparente à base d'alumine possédant une épaisseur de 50 nm à 150 nm, et ladite seconde couche de céramique transparente à base d'alumine possédant une épaisseur de 20 nm à 100 nm.

5. Elément optique selon l'une quelconque des revendications 1 à 4, ledit additif de séparation de phase comprenant du Na₂O, du CaO ou toute combinaison de ceux-ci.

6. Elément optique selon l'une quelconque des revendications 1 à 5, lesdites compositions indépendantes comprenant chacune un matériau choisi parmi MgAl₂O₄, l'oxynitrure d'aluminium ou toute combinaison de ceux-ci ; et/ou
ladite première couche de céramique transparente à base d'alumine possédant une structure non poreuse, de préférence ladite seconde couche de céramique transparente à base d'alumine possédant une structure poreuse.

7. Procédé de fabrication de l'élément optique selon l'une quelconque des revendications 1 à 6, le procédé comprenant :
la préparation d'un substrat transparent ;
le dépôt d'un matériau céramique à base d'alumine sur le substrat transparent, ledit matériau céramique à base d'alumine possédant une composition sans silice ; et
le traitement thermique et le lavage du matériau céramique à base d'alumine après le dépôt.

8. Procédé selon la revendication 7, ledit matériau céramique à base d'alumine possédant la composition sans silice possédant une composition choisie parmi MgAl₂O₄, l'oxynitrure d'aluminium ou toute combinaison de ceux-ci ;
ledit matériau céramique à base d'alumine possédant la composition sans silice comprenant en outre un additif de séparation de phases ; et/ou
ledit traitement thermique étant réalisé à une température de 400°C à 600°C pendant 1 heure ; et/ou
ledit traitement thermique et ledit lavage du matériau céramique à base d'alumine comprenant le traitement thermique et le lavage répétés du matériau céramique à base d'alumine entre une fois et trois fois, inclusivement, après le dépôt, de préférence ledit additif de séparation de phase comprenant du Na₂O, du CaO ou à la fois du Na₂O et du CaO.

9. Dispositif d'affichage comprenant l'élément optique selon l'une quelconque des revendications 1 à 6.
